# EUROPÄISCHE PATENTSCHRIFT

(11) **EP 2 089 644 B1**
(45) Veröffentlichungstag und Bekanntmachung des Hinweises auf die Patenterteilung: **25.02.2015**
(21) Anmeldenummer: 07820743.8
(22) Anmeldetag: 01.10.2007
(51) Int. Cl.: F16J 9/26, C23C 14/06, C23C 16/34, C23C 30/00

(54) **KOLBENRING FÜR VERBRENNUNGSKRAFTMASCHINEN**
PISTON RING FOR INTERNAL COMBUSTION ENGINES
SEGMENT DE PISTON POUR MOTEURS À COMBUSTION INTERNE

(30) Priorität: 04.10.2006 DE 102006046915
(43) Veröffentlichungstag der Anmeldung: 19.08.2009
(73) Patentinhaber: Federal-Mogul Burscheid GmbH, 51399 Burscheid (DE)
(72) Erfinder: FISCHER, Manfred, 42799 Leichlingen (DE); LAMMERS, Ralf, 42929 Wermelskirchen (DE); BAUER, Christiane, 51399 Burscheid (DE); HOPPE, Steffen, 51491 Overath (DE)
(74) Vertreter: Mehler Achler
(86) Internationale Anmeldenummer: PCT/EP2007/060357
(87) Internationale Veröffentlichungsnummer: WO 2008/040695

(56) Entgegenhaltungen:
- JP-A- 2005 060 810
- CHU X ET AL: "Deposition and properties of polycrystalline TiN/NbN superlattice coatings" JOURNAL OF VACUUM SCIENCE & TECHNOLOGY A (VACUUM, SURFACES, AND FILMS) USA, Bd. 10, Nr. 4, Juli 1992 (1992-07), Seiten 1604-1609, XP002481492 ISSN: 0734-2101
- HOVSEPIAN P E ET AL: "Recent progress in large-scale production of nanoscale multilayer/supe" VACUUM, PERGAMON PRESS, GB, Bd. 69, Nr. 1-3, 24. Dezember 2003 (2003-12-24), Seiten 27-36, XP008049315 ISSN: 0042-207X in der Anmeldung erwähnt

## Beschreibung

Die Erfindung betrifft einen Kolbenring aus einem Trägermaterial, insbesondere aus Stahl oder einem Gusswerkstoff, mit einer Verschleißschutzbeschichtung aus einem periodisch aufgebauten Viellagenschichtsystem, wobei jede Periodizität aus mindestens zwei Einzellagen aus Metallnitriden besteht.

Die Laufflächen von Kolbenringen in Verbrennungskraftmaschinen unterliegen während ihres Einsatzes einem Verschleiß. Um den Verschleiß zu minimieren, werden die Laufflächen der Kolbenringe mit einer Schutzschicht versehen.

Aus der JP 2005-082822 AA und JP 2005-187859 AA ist ein Trägermaterial mit einem Viellagenschichtsystem bekannt, das Metallnitridschichten aufweist. Hinweise auf unterschiedliche metallische Elemente in den Einzellagen aus Metallnitriden finden sich in beiden Vorveröffentlichungen nicht.

Die DE 44 41 136 A1 offenbart einen Druckring für einen Kolben einer Kolbenzylinderanordnung einer Kolbenbrennkraftmaschine. Die abriebfeste Beschichtung besteht aus einem Nitrid, wie CrN, Cr₂N, TiN, Ti/TiN oder ZrN. Die Beschichtung besteht lediglich aus einer einzigen Schicht. Hinweise auf ein Viellagenschichtsystem sind der DE 44 41 136 A1 nicht zu entnehmen.

Die JP 2002-256967 AA offenbart ein Gleitelement mit einer abriebfesten Beschichtung. Als Beispiel wird ein Kolbenring erwähnt, der eine Schicht auf Basis von Metallnitriden aufweist. Auch in dieser Vorveröffentlichung finden sich keine Hinweise auf Viellagenschichtsysteme.

Aus der DE 100 61 749 A1 ist eine Verschleißschutzbeschichtung für Kolbenringe in Verbrennungskraftmaschinen bekannt, die im Wesentlichen aus Chromcarbiden, Chrom, Nickel und Molybdän besteht. Ein aus diesen Komponenten bestehendes Pulver wird mittels Hochgeschwindigkeitsflammspritzen auf die Kolbenringe aufgebracht. Obwohl solche Schutzschichten hinsichtlich des Verschleißes gute Ergebnisse zeigten, ist die Rissbeständigkeit, insbesondere unter hohen Belastungen, wie sie in den neuartigen Dieselmotoren auftritt, nicht zufrieden stellend.

Aus dem Bereich hochbelasteter Werkzeuge, wie z. B. Schneidwerkzeuge, ist es seit langem bekannt, Viellagenschichtsysteme als Schutzschicht vorzusehen. Aus der DE 35 12 986 C2 ist eine Verschleißschutzbeschichtung bekannt, deren Einzellagendicken im Bereich von 0,5 bis 40 nm liegen. Soweit als Einzellage eine TiN-Schicht verwendet wird, so wird diese mit einer weiteren Einzellage aus einem Carbid oder einem Borid kombiniert.

Diese Viellagenschichttechnologie hat auch Eingang in die Herstellung von Kolbenringen gefunden. Aus der JP 2005-060810 A sind Kolbenringe für Verbrennungskraftmaschinen bekannt, die mit einem Viellagenschichtsystem versehen sind, deren Einzellagen dieselbe metallische Komponente aufweisen und sich lediglich im Stickstoffgehalt unterscheiden. Die Schichtdicken der Einzellagen werden mit < 1 µm angegeben. Die Schichten werden mittels eines PVD-Verfahrens, insbesondere eines Lichtbogenverfahrens, aufgebracht.

Die DE 10 2004 028 486 A1 beschreibt ein Gleitbauteil, wie z. B. Kolbenringe für Verbrennungsmotoren, das eine Beschichtung aus mehreren Einzellagen aufweist, die abwechselnd aus Chrom und Chromnitrid bestehen. Die Chromnitridschichten können aus CrN, Cr2N oder Mischungen hieraus bestehen. Zur Vermeidung schroffer Übergänge wird das Beschichtungsverfahren so gesteuert, dass die Chromnitrideinzellagen jeweils beiderseits einen Saum aus Cr2N und einen Kern aus CrN aufweisen. Jede Einzellage ist mindestens 0,01 µm dick. Die maximale Dicke beträgt 10 µm. Die Gesamtdicke der Beschichtung wird mit 5 bis 100 µm angegeben.

Diese bekannten Viellagenschichtsysteme haben jedoch den Nachteil, dass die Rissbeständigkeit nicht zufrieden stellend ist.

Dies gilt auch für Viellagenschichtsysteme mit Übergitterstrukturen.

Aus "Recent progress in large-scale production of nanoscale multilayer/superlattice hard coatings" von P.Eh. Hovsepian, W.-D. Münz in VACUUM 69 (2003), S. 27-36, werden solche Übergitter (superlattices) beschrieben, die sich dann einstellen, wenn die Einzellagen eines Viellagenschichtsystems eine Dicke im Bereich der Gitterdimensionen aufweisen. Die Eigenschaften des Viellagenschichtsystems weichen von den Materialeigenschaften der Einzellagen ab, so dass z. B. die Härte des Viellagenschichtsystems deutlich größer ist als die der Einzellagen. Es werden folgende Schichtsysteme mit einer Gesamtdicke von 1,6 bis 4 µm beschrieben:
TiAlCrN / TiAlYN, TiAlN / CrN, TiAlN / VN, Cr / C, CrN / NbN.

Die Dicke der Periodizität liegt im Bereich von 1,6 bis 4 nm, was bei einem Viellagenschichtsystem mit einer Periodizität aus zwei Einzellagen einer Einzellagendicke von 0,8 bis 2 nm entspricht. Bei Viellagenschichtsystemen aus TiN / VN liegt die Härte zwei bis dreimal höher als die der Einzellagen aus TiN bzw. VN.

Als verschleißbeständiges Viellagenschichtsystem wird das System TiAlN/VN beschrieben, dessen Periodizität mit 3 nm angegeben wird. Die Werte für die plastische Härte liegen bei 406 Pa. Bei hohen mechanischen Belastungen im ungeschmierten Verschleißtest gegen eine Kugel aus 100 Cr 6 tritt allerdings durch die Vereinigung von Rissen die Ablösung von mehreren Einzellagen in der Größenordnung von 8 bis 10 nm auf.

Aufgrund dieser Nachteile konnten die Viellagenschichtsysteme mit Übergitterstrukturen bisher noch nicht bei hochbelasteten Gleitanwendungen, insbesondere bei Kolbenringen, zum Einsatz kommen.

Ein weiterer Nachteil besteht darin, dass wegen der großen Härte die Zylinderlaufbahn im Motor zu stark verschleißt. Auch aus diesem Grund sind diese bekannten Viellagenschichtsysteme für Kolbenringe nicht geeignet.

Ausgehend von der JP 2005-060810 A ist es Aufgabe der Erfindung, einen Kolbenring mit einem Viellagenschichtsystem zu versehen, das bei guter Verschleißbeständigkeit weniger rissanfällig ist und die Zylinderlaufbahn nur minimal verschleißt.

Diese Aufgabe wird mit einem Kolbenring gelöst, bei dem das Viellagenschichtsystem ein Übergitter aufweist, wobei die Dicke einer Einzellage ≥2 bis <15 nm beträgt und die Dicke des Viellagenschichtsystems >4,5 µm beträgt, wobei benachbarte Einzellagen innerhalb einer Periodizität unterschiedliche metallische Elemente aufweisen.

Übergitterstrukturen entstehen durch die gestörte Gitteranordnung in der unmittelbaren Nähe zu dem Gitter der benachbarten Einzellage. Die Einzellagen beeinflussen sich im Grenzbereich, so dass die Gitterparameter dort verändert sind. Aufgrund der relativ großen Dicke der Einzellagen, die beispielsweise durch 7 bis 35 Atomlagen gebildet werden, entsteht in jeder Einzellage ein Kernbereich, in dem sich ein Gitter ausbildet, das dem einer Einlagenschicht entspricht. Dieser Kernbereich wird von einer Übergitterstruktur zu den Lagengrenzen hin gesäumt.

Zwischen der Übergitterstruktur und der ungestörten Kernstruktur gibt es eine kontinuierliche Anpassung der Gitterparameter und damit eine kontinuierliche Anpassung des energetischen Zustandes des Gitters. Wenn ein Riss auftreten sollte, läuft dieser zunächst in den Übergitterbereich, wo er bereits abgebremst, aber nicht immer aufgehalten wird. Setzt sich der Riss fort, läuft er durch das sich kontinuierlich ändernde Gitter bis in den Kernbereich der Einzellage. Der Vorteil besteht darin, dass die Rissenergie kontinuierlich immer stärker aufgenommen und der Riss dabei kontinuierlich abgelenkt bzw. gestoppt wird. Die Rissausbreitung wird dadurch früher gestoppt, als dies bei reinen Übergitterstrukturen ohne die beschriebenen Kernbereiche der Fall ist.

Ein weiterer Vorteil besteht darin, dass durch die Kernbereiche die Härte, die in den Übergitterbereichen typischerweise höher ist, reduziert wird, so dass dadurch der Verschleiß der Zylinderlaufbahn minimiert wird.

Es hat sich herausgestellt, dass ein Viellagenschichtsystem aus MetallNitridschichten einerseits eine gute Verschleißbeständigkeit aufweist und andererseits durch die Verwendung unterschiedlicher Metalle für die benachbarten Einzellagen innerhalb der Periodizität eine geringe Rissanfälligkeit besitzt. Durch die Verwendung unterschiedlicher Metalle für die Metallnitride der Einzellagen können die Härte- und die Elastizitätseigenschaften des Schichtverbundes eingestellt werden.

Die Lebensdauer von Kolbenringen mit einem derartigen Viellagenschichtsystem ist deutlich höher als bei Kolbenringen mit einer herkömmlichen Einzellage oder mit einem Viellagenschichtsystem, das zwar ebenfalls aus Nitridschichten besteht, in denen aber lediglich der Stickstoffgehalt bei gleicher metallischer Komponente verändert wird.

Es hat sich ferner gezeigt, dass durch die große Gesamtdicke von mehr als 4,5 µm und die dadurch bedingte große Anzahl von Einzellagen, die mehr als 300 beträgt, das gesamte Schichtsystem offensichtlich eine größere Duktilität aufweist als dies bei dünneren Schichtsystemen der Fall ist, was die Rissanfälligkeit weiter reduziert.

Vorzugsweise weisen die Einzellagen Nitride mindestens eines Metalls aus der Gruppe Titan (Ti), Zirkonium (Zr), Hafnium (Hf), Vanadium (V), Niob (Nb), Tantal (Ta), Chrom (Cr), Molybdän (Mo) und Wolfram (W) auf.

Grundsätzlich sind alle Kombinationen von Nitriden der genannten Metalle möglich. Dabei kann es sich um stöchiometrische Phasen oder um nicht stöchiometrische Phasen oder Mischungen daraus handeln. Zum Beispiel soll unter CrN eine oder mehrere Phasen aus dem System Cr-N verstanden werden, analog gilt das für die anderen Systeme. Je nach Beschichtungsverfahren kann eventuell die eine oder andere Kombination bevorzugt sein.

Besonders bevorzugt ist die Verwendung von CrN für mindestens eine Einzellage der Periodizität. CrN kann im Viellagenschichtsystem mit den Nitriden aller anderen Metalle der genannten Gruppe kombiniert werden.

Bevorzugte Einzellagenkombinationen sind CrN / TiN, CrN / ZrN oder CrN / VN.

Die Periodizität kann auch mehr als zwei Einzellagen, vorzugsweise bis zu vier Einzellagen, aufweisen. Zwei Einzellagen sind insofern bevorzugt, weil der Herstellungsaufwand mit zunehmender Einzellagenanzahl pro Periodizität deutlich zunimmt.

Vorzugsweise enthält mindestens eine Einzellage der Periodizität > 0 bis 15 Gew.%, insbesondere 3 bis 8 Gew.%, mindestens eines der Dotierelemente Aluminium, Silicium oder Kohlenstoff. Diese Dotierelemente bewirken, dass die Verschleißschutzschichten höhere Oxidationsbeständigkeiten und geringere Reibwerte aufweisen.

Vorzugsweise sind die Dotierelemente benachbarter Einzellagen unterschiedlich. Die Unterschiede in den Eigenschaften der benachbarten Einzellagen werden durch die Zugabe der Dotierelemente zusätzlich vergrößert, was sich besonders günstig auf die Verhinderung der Rissausbreitung senkrecht zu den Einzellagen auswirkt.

Es ist auch möglich, dass mindestens eine der Einzellagen der Periodizität Nitride aus mindestens zwei Metallen aus der Gruppe Ti, Zr, Hf, V, Nb, Ta, Cr, Mo und W enthält, wobei benachbarte Einzellagen sich in mindestens einem metallischen Element unterscheiden.

Bevorzugte Metallkombinationen der Nitride für mindestens eine Einzellage der Periodizität bestehen aus den Systemen Ti-Zr-N, Ti-Al-N, Cr-Si-N, Cr-Zr-N, Cr-Ti-N oder Cr-V-N. Die genannten Metallkombinationen können auch die genannten Dotierelemente aufweisen. Die Vorteile dieser Metallkombinationen für die Einzellagen bestehen darin, dass die jeweiligen Materialeigenschaften variiert und angepasst werden können.

Nach einer Periodizität oder mehreren Periodizitäten kann mindestens eine Zwischenlage aus mindestens einem der Metalle Ti, Zr, Hf, V, Nb, Ta, Cr, Mo, W vorgesehen sein. Die Vorteile dieser Zwischenlagen bestehen darin, dass sie als duktile Metalle in der Lage sind, die Rissausbreitung umzulenken bzw. zu stoppen und die Gesamtduktilität des Viellagenverbandes deutlich zu erhöhen, so dass die Gesamteigenspannungen reduziert werden können. Dies ist wichtig insbesondere für die Abscheidung von Verschleißschutzschichten, die zur Erhöhung der Lebensdauer mit höherer Schichtdicke abgeschieden werden.

Vorzugsweise ist zwischen dem Trägermaterial und der ersten Einzellage mindestens eine Haftschicht vorgesehen, die aus mindestens einem der Metalle Ti, Zr, Hf, V, Nb, Ta, Cr, Mo und W bestehen kann.

Eine Einsparung wird erzielt, wenn das Haftschichtmaterial mit dem Material der Zwischenlage oder mit dem Metall einer Einzellage identisch ist. Das Abscheideverfahren muss dann lediglich über die Zusammensetzung des Prozeßgases modifiziert werden.

Bevorzugte Haftschichtmaterialien sind Chrom und Titan, insbesondere bei Trägerwerkstoffen aus Stahl, weil sie eine besonders gute Haftung auf Stahlwerkstoffen aufweisen.

Die Dicke einer Einzellage beträgt vorzugsweise 5 nm bis <15 nm, besonders bevorzugt 8 nm bis <15 nm und besonders bevorzugt 10 nm bis <15 nm.

Es hat sich gezeigt, dass sich bezüglich der Verschleißbeständigkeit für jede Materialkombination der Einzellagen ein optimaler Wert für die Periodizität ergibt.

Die Dicke des Viellagenschichtsystems beträgt vorzugsweise >4,5 µm bis 60 µm, besonders bevorzugt 5 µm bis 60 µm, insbesondere 10 µm bis 40 µm. Diese Dicken liegen unterhalb der Dicken, die für Schichten nach dem Stand der Technik, z. B. für eine einlagige Chromnitridschicht benötigt werden, um dieselbe Einsatzdauer zu gewährleisten. Durch die Dickenverringerung der Verschleißschutzbeschichtung wird Material und Zeit bei der Herstellung der Beschichtung eingespart.

Vorzugsweise ist das Viellagenschichtsystem mittels eines PVD-Verfahrens aufgebracht.

Mittels der PVD-Verfahren lassen sich besonders günstig die Metallnitride TiN, ZrN, VN, CrN und MoN auftragen.

Als bevorzugtes Verfahren ist das Lichtbogenverfahren vorgesehen, um das Viellagenschichtsystem aufzubringen.

Das Viellagenschichtsystem kann auch mittels eines CVD-Verfahrens aufgebracht werden.

Die besondere Verwendung solcher erfindungsgemäßer Kolbenringe ist für Dieselmotoren und Ottomotoren vorgesehen.

Die Verschleißschutzbeschichtung ist insbesondere für Kompressionsringe und für Ölringe geeignet.

Beispielhafte Ausführungsformen der Erfindung werden nachfolgend anhand der Zeichnungen näher erläutert.

Es zeigen:
- Figur 1: einen Kolbenring in perspektivischer Darstellung,
- Figur 2: einen Schnitt längs der Linie II-II durch den in Figur 1 gezeigten Kolbenring,
- Figur 3: eine vergrößerte Darstellung der Einzelheit X aus Figur 2,
- Figur 4: eine vergrößerte Darstellung der Einzelheit Y aus Figur 3,
- Figur 5: eine schematische Darstellung eines Viellagenschichtsystems gemäß einer weiteren Ausführungsform.

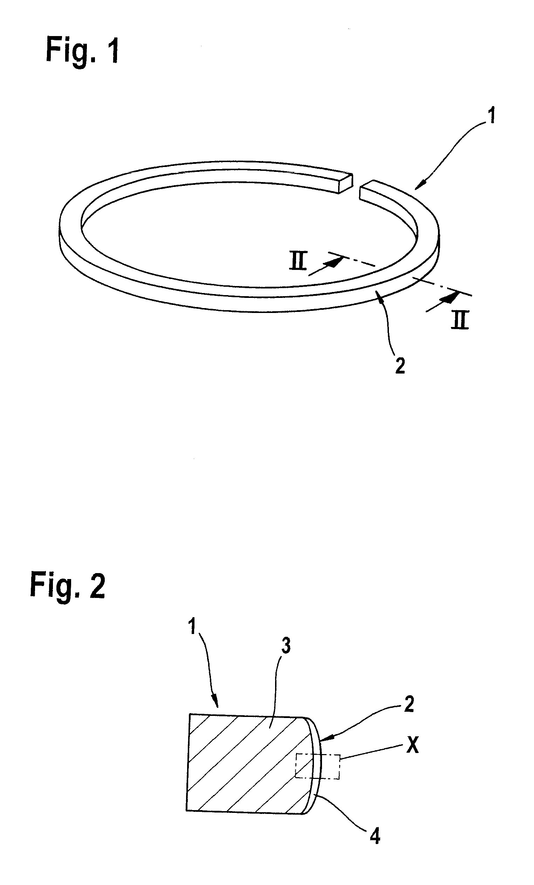

In der Figur 1 ist ein Kolbenring 1 perspektivisch dargestellt. Die Außenumfangsfläche bildet die Lauffläche 2.

In der Figur 2 ist ein Schnitt längs der Linie II-II durch den in Figur 1 gezeigten Kolbenring 1 dargestellt. Die Lauffläche 2 hat eine leicht ballige Form. Die auf dem Trägermaterial 3 abgeschiedene Verschleißschutzbeschichtung 4 bildet diese ballige Form ab.

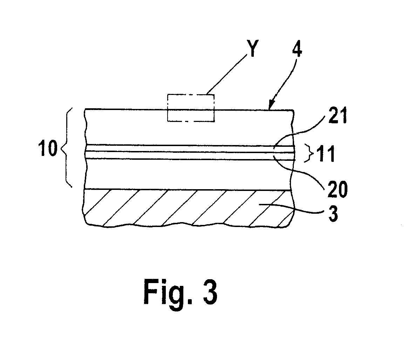

In der Figur 3 ist eine vergrößerte Darstellung der Einzelheit X aus der Figur 2 dargestellt. Auf dem Trägermaterial 3 befindet sich das Viellagenschichtsystem 10, das aus einer Vielzahl von Periodizitäten 11 gebildet wird. Jede Periodizität 11 besteht aus zwei Einzellagen 20, 21, wobei der Übersichtlichkeit halber lediglich eine Periodizität 11 eingezeichnet ist.

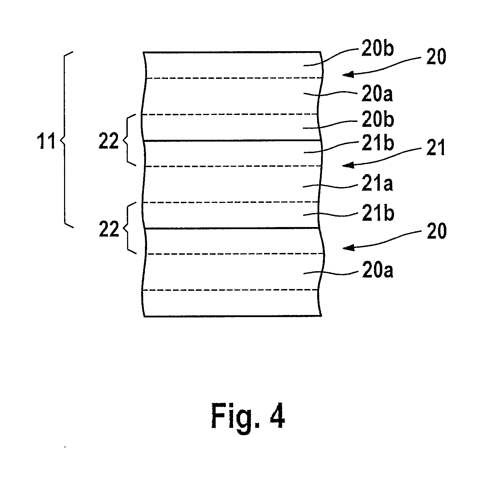

In der Figur 4 ist eine Vergrößerung der Einzelheit Y aus Figur 3 dargestellt. Übergitterstrukturen entstehen durch die gestörte Gitteranordnung in der unmittelbaren Nähe zu dem Gitter der benachbarten Einzellage 20, 21. Die Einzellagen 20, 21 beeinflussen sich im Grenzbereich 22, so dass die Gitterparameter dort verändert sind. Aufgrund der relativ großen Dicke der Einzellagen 20, 21, die beispielsweise durch 7 bis 35 Atomlagen gebildet werden, entsteht in jeder Einzellage 20, 21 ein Kernbereich 20a, 21 a, in dem sich ein Gitter ausbildet, das dem einer Einlagenschicht entspricht. Dieser Kernbereich wird von einer Übergitterstruktur 20b, 21 b zu den Lagengrenzen hin gesäumt.

In der nachfolgenden Tabelle 1 sind die bevorzugten Metalle der Metallnitride in einer Matrix dargestellt. Alle Metallnitridkombinationen für die benachbarten Einzellagen sind mit der Ausnahme der Identität erfindungsgemäß vorgesehen. Die besonders bevorzugten Metallnitridkombinationen sind durch X gekennzeichnet.

**Tabelle 1 (Metalle der Metallnitride)**

| System Nr. | | Ti | Zr | Hf | V | Nb | Ta | Cr | Mo | W |
|---|---|---|---|---|---|---|---|---|---|---|
| 1 | Ti | | X | X | X | X | X | X | X | X |
| 2 | Zr | X | | X | X | X | X | X | X | X |
| 3 | Hf | X | X | | X | | | X | | |
| 4 | V | X | X | X | | X | X | X | X | X |
| 5 | Nb | X | X | | X | | | X | | |
| 6 | Ta | X | X | | X | | | X | | |
| 7 | Cr | X | X | X | X | X | X | | X | X |
| 8 | Mo | X | X | | X | | | X | | |
| 9 | W | X | X | | X | | | X | | |

Die System-Nummer 7, wonach immer eine CrN-Schicht als Einzellage innerhalb der Periodizität beteiligt ist, ist durch eine besonders gute Stabilität des Viellagenschichtsystems ausgezeichnet. Die System-Nummern 1, 2 und 4 bezeichnen Metallnitridkombinationen, die sich besonders günstig im Lichtbogenverfahren abscheiden lassen.

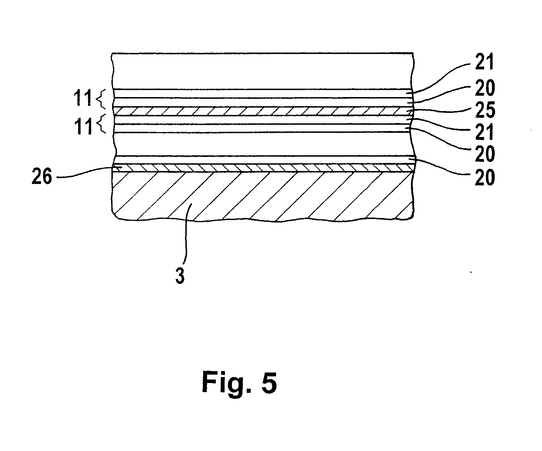

In der Figur 5 ist schematisch ein Viellagenschichtsystem 10 gemäß einer weiteren Ausführungsform dargestellt. Zwischen den Periodizitäten 11 ist jeweils eine Zwischenlage 25 vorgesehen. Außerdem ist zwischen der ersten Einzellage und dem Trägermaterial 3 eine Haftschicht 26 vorgesehen. Es ist auch möglich, nur eine Haftschicht oder nur Zwischenlagen vorzusehen.

### Bezugszeichenliste

- 1: Kolbenring
- 2: Lauffläche
- 3: Trägermaterial
- 4: Verschleißschutzbeschichtung

- 10: Viellagenschichtsystem
- 11: Periodizität

- 20: Einzellage
- 20a: Kernbereich
- 20b: Übergitterstruktur
- 21: Einzellage
- 21a: Kernbereich
- 21b: Übergitterstruktur
- 22: Grenzbereich
- 25: Zwischenlage
- 26: Haftschicht

## Patentansprüche

1. Kolbenring (1) aus einem Trägermaterial (3), insbesondere aus Stahl oder einem Gusswerkstoff, und mit einer Verschleißschutzbeschichtung (4) aus einem periodisch aufgebauten Viellagenschichtsystem (10), wobei jede Periodizität (11) aus mindestens zwei Einzellagen (20, 21) aus Metallnitriden besteht, **dadurch gekennzeichnet, dass** das Viellagenschichtsystem Übergitterstrukturen aufweist, wobei die Dicke einer Einzellage (20, 21) ≥ 2 nm bis <15 nm beträgt und die Dicke des Viellagenschichtsystems >4,5 µm beträgt, und dass benachbarte Einzellagen (20, 21) innerhalb einer Periodizität (11) unterschiedliche metallische Elemente aufweisen.

2. Kolbenring nach Anspruch 1, **dadurch gekennzeichnet, dass** die Einzellagen (20, 21) Nitride mindestens eines Metalls aus der Gruppe Ti, Zr, Hf, V, Nb, Ta, Cr, Mo und W aufweisen.

3. Kolbenring nach Anspruch 1 oder 2, **dadurch gekennzeichnet, dass** mindestens eine Einzellage (20, 21) der Periodizität (11) aus CrN besteht.

4. Kolbenring nach einem der Ansprüche 1 bis 3, **dadurch gekennzeichnet, dass** jede Periodizität (11) aus zwei Einzellagen (20, 21) aus CrN und TiN (CrN / TiN), CrN und ZrN (CrN / ZrN) oder CrN und VN (CrN / VN) besteht.

5. Kolbenring nach einem der Ansprüche 1 bis 4, **dadurch gekennzeichnet, dass** mindestens eine der Einzellagen (20, 21) der Periodizität > 0 bis 15 Gew.% mindestens eines der Dotierelemente Aluminium, Silicium oder Kohlenstoff enthält.

6. Kolbenring nach Anspruch 5, **dadurch gekennzeichnet, dass** die Dotierelemente benachbarter Einzellagen (20, 21) unterschiedlich sind.

7. Kolbenring nach einem der Ansprüche 1 bis 6, **dadurch gekennzeichnet, dass** mindestens eine der Einzellagen (20, 21) der Periodizität Nitride aus mindestens zwei Metallen aus der Gruppe Ti, Zr, Hf, V, Nb, Ta, Cr, Mo und W enthält, wobei benachbarte Einzellagen (20, 21) sich in mindestens einem metallischen Element unterscheiden.

8. Kolbenring nach Anspruch 7, **dadurch gekennzeichnet, dass** mindestens eine Einzellage (20, 21) der Periodizität aus den Systemen Ti-Zr-N, Ti-Al-N, Cr-Si-N, Cr-Zr-N, Cr-Ti-N oder Cr-V-N besteht.

9. Kolbenring nach einem der Ansprüche 1 bis 8, **dadurch gekennzeichnet, dass** nach einer oder mehreren Periodizitäten (11) mindestens eine Zwischenlage (25) aus mindestens einem der Metalle Ti, Zr, Hf, V, Nb, Ta, Cr, Mo und W vorgesehen ist.

10. Kolbenring nach einem der Ansprüche 1 bis 9, **dadurch gekennzeichnet, dass** zwischen dem Trägermaterial (3) und der Verschleißschutzschicht (4) mindestens eine Haftschicht (26) vorgesehen ist.

11. Kolbenring nach Anspruch 10, **dadurch gekennzeichnet, dass** die Haftschicht (26) aus mindestens einem der Metalle Ti, Zr, Hf, V, Nb, Ta, Cr, Mo und W besteht.

12. Kolbenring nach einem der Ansprüche 1 bis 11, **dadurch gekennzeichnet, dass** die Dicke einer Einzellage 5 nm bis <15 nm, bevorzugt 8 bis <15 nm und besonders bevorzugt 10 nm bis <15 nm beträgt.

13. Kolbenring nach einem der Ansprüche 1 bis 12, **dadurch gekennzeichnet, dass** die Dicke des Viellagenschichtsystems (10) >4,5 µm bis 60 µm, bevorzugt 5 µm bis 60 µm, besonders bevorzugt 10 µm bis 40 µm beträgt.

14. Kolbenring nach einem der Ansprüche 1 bis 13, **dadurch gekennzeichnet, dass** das Viellagenschichtsystem (10) mittels eines PVD-Verfahrens aufgebracht ist.

15. Verwendung eines Kolbenrings nach Anspruch 1 in Dieselmotoren oder Ottomotoren.

## Claims

1. Piston ring (1) comprising a carrier material (3), in particular of steel or a cast material, and having a wear protection coating (4) of a periodically constructed multi- layer coating system (10), each periodicity (11) consists of at least two individual layers (20, 21) of metal nitrides, **characterised in that** the multi-layer coating system has superlattice structures, the thickness of an individual layer (20, 21) being from ≥ 2 nm to < 15 nm and the thickness of the multi-layer coating system being > 4.5 µm, and **in that** adjacent individual layers (20, 21) have different metallic elements within a periodicity (11).

2. Piston ring according to claim 1, **characterised in that** the individual layers (20, 21) have nitrides of at least one metal from the group Ti, Zr, Hf, V, Nb, Ta, Cr, Mo and W.

3. Piston ring according to claim 1 or claim 2, **characterised in that** at least one individual layer (20, 21) of the periodicity (11) consists of CrN.

4. Piston ring according to any one of claims 1 to 3, **characterised in that** each periodicity (11) consists of two individual layers (20, 21) of CrN and TiN (CrN/TiN), CrN and ZrN (CrN/ZrN) or CrN and VN (CrN/VN).

5. Piston ring according to any one of claims 1 to 4, **characterised in that** at least one of the individual layers (20, 21) of the periodicity contains > 0 to 15% by weight of at least one of the doping elements aluminium, silicon or carbon.

6. Piston ring according to claim 5, **characterised in that** the doping elements of adjacent individual layers (20, 21) are different.

7. Piston ring according to any one of claims 1 to 6, **characterised in that** at least one of the individual layers (20, 21) of the periodicity contains nitrides of at least two metals from the group Ti, Zr, Hf, V, Nb, Ta, Cr, Mo and W, adjacent individual layers (20, 21) differing from each other in terms of at least one metal element.

8. Piston ring according to claim 7, **characterised in that** at least one individual layer (20, 21) of the periodicity consists of the systems Ti-Zr-N, Ti-Al-N, Cr-Si-N, Cr-Zr-N, Cr-Ti-N or Cr-V-N.

9. Piston ring according to any one of claims 1 to 8, **characterised in that** after one or more periodicities (11) at least one intermediate layer (25) of at least one of the metals Ti, Zr, Hf, V, Nb, Ta, Cr, Mo and W is provided.

10. Piston ring according to any one of claims 1 to 9, **characterised in that** between the carrier material (3) and the wear protection layer (4) at least one adhesive layer (26) is provided.

11. Piston ring according to claim 10, **characterised in that** the adhesive layer (26) consists of at least one of the metals Ti, Zr, Hf, V, Nb, Ta, Cr, Mo and W.

12. Piston ring according to any one of claims 1 to 11, **characterised in that** the thickness of an individual layer is from 5 nm to < 15 nm, preferably from 8 to < 15 nm and in a particularly preferred manner from 10 nm to < 15 nm.

13. Piston ring according to any one of claims 1 to 12, **characterised in that** the thickness of the multi-layer coating system (10) is > 4.5 µm to 60 µm, preferably from 5 µm to 60 µm, in a particularly preferred manner from 10 µm to 40 µm.

14. Piston ring according to any one of claims 1 to 13, **characterised in that** the multi-layer coating system (10) is applied by means of a PVD method.

15. Use of a piston ring according to claim 1 in diesel engines or Otto engines.

## Revendications

1. Segment de piston (1) réalisé dans un matériau de support (3), en particulier en acier ou en fonte, et présentant un revêtement anti-usure (4) réalisé dans un système multicouche (10) de structure périodique, chaque périodicité (11) étant constituée d'au moins deux couches individuelles (20, 21) en nitrures métalliques, **caractérisé en ce que** le système multicouche présente des structures de réseau superposé, l'épaisseur d'une couche individuelle (20, 21) étant ≥ 2 nm et < 15 nm et l'épaisseur du système multicouche étant > 4,5 µm, et que des couches individuelles (20, 21) adjacentes à l'intérieur d'une périodicité (11) présentent des éléments métalliques différents.

2. Segment de piston selon la revendication 1, **caractérisé en ce que** les couches individuelles (20, 21) présentent des nitrures d'au moins un métal choisi dans le groupe formé par Ti, Zr, Hf, V, Nb, Ta, Cr, Mo et W.

3. Segment de piston selon la revendication 1 ou 2, **caractérisé en ce qu'**au moins une couche individuelle (20, 21) de la périodicité (11) est constituée de CrN.

4. Segment de piston selon l'une des revendications 1 à 3, **caractérisé en ce que** chaque périodicité (11) est constituée de deux couches individuelles (20, 21) en CrN et TiN (CrN/TiN), CrN et ZrN (CrN/ZrN) ou CrN et VN (CrN/VN).

5. Segment de piston selon l'une des revendications 1 à 4, **caractérisé en ce qu'**au moins une des couches individuelles (20, 21) de la périodicité contient > 0 à 15 % en poids d'au moins un des éléments de dopage aluminium, silicium ou carbone.

6. Segment de piston selon la revendication 5, **caractérisé en ce que** les éléments de dopage de couches individuelles (20, 21) adjacentes sont différents.

7. Segment de piston selon l'une des revendications 1 à 6, **caractérisé en ce qu'**au moins une des couches individuelles (20, 21) de la périodicité contient des nitrures d'au moins deux métaux choisis dans le groupe formé par Ti, Zr, Hf, V, Nb, Ta, Cr, Mo et W, des couches individuelles (20, 21) adjacentes différant par au moins un élément métallique.

8. Segment de piston selon la revendication 7, **caractérisé en ce qu'**au moins une couche individuelle (20, 21) de la périodicité est constituée des systèmes Ti-Zr-N, Ti-Al-N, Cr-Si-N, Cr-Zr-N, Cr-Ti-N ou Cr-V-N.

9. Segment de piston selon l'une des revendications 1 à 8, **caractérisé en ce qu'**après une ou plusieurs périodicités (11), au moins une couche intermédiaire (25) constituée d'au moins un des métaux Ti, Zr, Hf, V, Nb, Ta, Cr, Mo et W est prévue.

10. Segment de piston selon l'une des revendications 1 à 9, **caractérisé en ce qu'**au moins une couche adhésive (26) est prévue entre le matériau de support (3) et la couche anti-usure (4).

11. Segment de piston selon la revendication 10, **caractérisé en ce que** la couche adhésive (26) est constituée d'au moins un des métaux Ti, Zr, Hf, V, Nb, Ta, Cr, Mo et W.

12. Segment de piston selon l'une des revendications 1 à 11, **caractérisé en ce que** l'épaisseur d'une couche individuelle est de 5 nm jusqu'à < 15 nm, de préférence de 8 nm jusqu'à < 15 nm et de manière particulièrement préférée de 10 nm jusqu'à < 15 nm.

13. Segment de piston selon l'une des revendications 1 à 12, **caractérisé en ce que** l'épaisseur du système multicouche (10) est de > 4,5 µm jusqu'à 60 µm, de préférence de 5 µm jusqu'à 60 µm, de manière particulièrement préférée de 10 µm jusqu'à 40 µm.

14. Segment de piston selon l'une des revendications 1 à 13, **caractérisé en ce que** le système multicouche (10) est appliqué au moyen d'un procédé PVD.

15. Utilisation d'un segment de piston selon la revendication 1 dans des moteurs diesel ou des moteurs à essence.
